# EUROPEAN PATENT SPECIFICATION

(11) **EP 0 955 674 B1**
(45) Date of publication and mention of the grant of the patent: **13.07.2011**
(21) Application number: 99104656.6
(22) Date of filing: 09.03.1999
(51) Int. Cl.: H01L 21/84, H01L 27/12

(54) **Fabrication of hybrid polycrystalline and amorphous silicon structures**
Herstellung von hybriden polykristallinen und amorphen Siliziumstrukturen
Fabrication de structures hybrides à silicium polycristallin et amorphe

(30) Priority: 28.04.1998 US 67880
(43) Date of publication of application: 10.11.1999
(73) Proprietor: Xerox Corporation, Rochester, NY 14644 (US)
(72) Inventor: Mei, Ping, Palo Alto, CA 94306 (US); Lujan, Rene A., Sunnyvale, CA 94086 (US)
(74) Representative: Grünecker, Kinkeldey, Stockmair & Schwanhäusser Anwaltssozietät

(56) References cited:
- US-A- 5 032 233
- US-A- 5 294 811
- US-A- 5 585 647
- KAZUHIRO SHIMIZU ET AL: "ON-CHIP BOTTOM-GATE POLYSILICON AND AMORPHOUS SILICON THIN-FILM TRANSISTORS USING EXCIMER LASER ANNEALING" JAPANESE JOURNAL OF APPLIED PHYSICS, PUBLICATION OFFICE JAPANESE JOURNAL OF APPLIED PHYSICS. TOKYO, JP, vol. 29, no. 10 PART 2, 1 October 1990 (1990-10-01), pages L1775-L1777, XP000220605 ISSN: 0021-4922
- PATENT ABSTRACTS OF JAPAN vol. 0184, no. 54 (P-1791), 24 August 1994 (1994-08-24) & JP 6 148686 A (CASIO COMPUT CO LTD), 27 May 1994 (1994-05-27)

## Description

### BACKGROUND

The present invention relates generally to the field of semiconductor device manufacturing, and more particularly to a method of fabricating circuits comprised of both polycrystalline and amorphous silicon devices in close proximity to one another.

Amorphous silicon (a-Si) is a material commonly employed for example in large-area electronic devices such image sensors, displays, etc. Active matrix liquid crystal displays (AMLCDs), for instance, may be comprised of 7 million or more pixels formed on a sheet of glass 25 cm by 20 cm or larger, where each pixel includes one or more transistors formed in part of a-Si. A two dimensional (2-d) imager with a similar pixel count may be 46.5 cm by 36 cm, for example. In addition to the pixel transistor(s), AMLCDs, image sensors, and the like often require related circuitry such as drivers, decoders, etc. It is desirable to integrate this related circuitry onto the glass substrate to reduce size, cost, etc. Most commonly, this related circuitry is located at the periphery of the pixel array on the substrate.

It is well recognized that devices fabricated from a-Si are relatively slow due to the poor carrier mobility in a-Si. While adequately fast to serve as pixel thin film transistors (TFTs), a-Si transistors are considered too slow to provide adequate performance of the related circuitry. One technique employed to address this shortfall of a-Si devices has been to use polycrystalline silicon (poly-Si) devices for the related circuitry. Poly-Si TFTs, for example, provide a 20 to 100-fold improvement in carrier mobility over a-Si TFTs, thus proportionally increasing device speed. Poly-Si devices may be formed on the same substrate as a-Si devices, the processing steps being compatible for the two different materials.

However, it is also well recognized that a-Si devices provide some advantages over poly-Si devices. Poly-Si TFTs have a higher leakage current, for example more than two orders of magnitude, than similar a-Si devices, which is undesirable for applications such as 2-d imaging arrays. Thus, it is preferred to exploit the desirable properties of both a-Si and poly-Si devices in a single array. A structure comprised of both a-Si and poly-Si devices on a shared substrate is referred to herein as a hybrid structure.

One method disclosed in the art for forming poly-Si TFTs on a shared substrate with a-Si TFTs is referred to as laser crystallization. There are numerous embodiments of laser crystallization. According to one such embodiment, a SiO₂ gate insulation film is grown on a highly doped single crystal silicon substrate which serves as a gate electrode. An a-Si film is next deposited by chemical vapor deposition (CVD) onto the SiO₂ film. The a-Si film is then crystallized by excimer laser annealing, and hydrogenated by further annealing in the presence of hydrogen. Aluminum patterned over the top of this structure provides the electrical contacts. A method of this type is taught by Shimizu et al. in "On-Chip Bottom-Gate Polysilicon and Amorphous Silicon Thin-Film Transistors Using Excimer Laser Annealing," Japanese J. of Appl. Phys., vol. 29, no. 10 pp. 1775 et seq. (Oct. 1990). A similar method taught by U.S. patent 5,366, 926 employs a pulsed laser to crystallize a-Si material to form a poly-Si channel for a TFT.

JP 06 148686 A discloses a matrix circuit driving device. A gate electrode is provided in the lower side of a semiconductor thin film and a gate electrode is provided on the upper side of a semiconductor thin film both films being made of amorphous Si for the beginning. Laser irradiation results in partial crystallization with a channel region left in the state of amorphous Si.

US 5,032,233 discloses step coverage of metallization layers of an integrated circuit wherein a deposited layer of a high melting point is used as an anti-reflective coating to increase the efficient use of laser energy for planarization purposes.

Known techniques for laser crystallization have several disadvantages. For example, it has been commonly assumed that poly-Si devices would be formed on the substrate periphery, thus relatively far away from a-Si devices. In such case, limited or no masking is required. And if a mask is needed, a shadow mask protecting the a-Si device from the laser during the crystallization process is adequate. However, recent pixel designs for high performance arrays include poly-Si and a-Si devices in very close proximity to one another, for example on the order of 5 µm or less from edge to adjacent edge. This is not possible from current process, which are designed for separations between poly-Si and a-Si devices on the order of 3 mm. New techniques and structures are required to provide this close spacing between devices.

### SUMMARY

The present invention is a novel process which overcomes the disadvantages referred to above. In particular, we have discovered a novel process for the formation of a device, such as a TFT, having a poly-Si conductive region formed from what was originally an a-Si layer. Furthermore, the process is ideally suited to the formation of a-Si and poly-Si devices on a shared substrate at a spacing of between 2 and 50 µm. Minimal additional processing is required over existing techniques, and all additional steps and materials are compatible with existing manufacturing processes.

The present invention provides a method of producing a structure of at least two devices on a shared substrate, each said device having a region of conductive material in one of two crystalline states, said structure containing at least two said devices having different crystalline states adjacent one another, comprising the steps of:
forming first and second contact regions on the substrate;
forming a first insulating layer over and in contact with said first and second contact regions and the substrate;
depositing a layer of conductive material having a first crystalline state over and in contact with said first insulating layer such that there is a region of conductive material overlying said first contact region and a region of conductive material overlying said second contact region;
depositing a second insulating layer over and in contact with said layer of conductive material;
depositing a masking layer over and in contact with said second insulating layer such that said masking layer overlays said first contact region but not said second contact region; and
selectively altering the crystalline state of said layer of conductive material from a first crystalline state to a second crystalline state at least in the region overlying said second contact region, said masking layer serving to prevent the crystalline state of the region of said conductive layer overlying said first contact region from being altered to said second crystalline state;
and wherein
each said device has either an amorphous or polycrystalline silicon layer, said structure containing at least one device having an amorphous silicon layer adjacent at least one device having a polycrystalline silicon layer, and
said formed first and second contact regions are first and second gate lines;
said first formed insulating layer is a first dielectric layer;
said deposited layer of a conductive material is a hydrogenated amorphous silicon layer over and in contact with said first dielectric layer such that there is a region of amorphous silicon overlying said first gate line and a region of amorphous silicon overlying said second gate line;
said second formed insulating layer is a second dielectric layer over and in contact with said hydrogenated amorphous silicon layer;
wherein said step of selectively altering consists of:
crystallizing said amorphous silicon layer at least in the region overlying said second gate line by irradiating said amorphous silicon layer with a laser beam, thereby converting a region of said amorphous silicon layer into a region of polycrystalline silicon, said masking layer serving to prevent the crystallization of the amorphous silicon layer overlaying said first gate line;
and further comprising the steps of
introducing hydrogen atoms into the polycrystalline silicon region;
depositing a third dielectric layer over and in contact with at least the polycrystalline silicon region;
forming an absorption layer over and in contact with said third dielectric layer overlying at least said polycrystalline silicon region;
forming a photoresist layer overlying at least said first and second gate lines;
forming islands of dielectric material overlying said first and second gate lines by back side lithography, using said first and second gate lines as masks, said absorption layer absorbing sufficient energy from the back side lithography process so as to compensate for any difference in the transparency of the amorphous silicon and polycrystalline silicon regions;
forming a doped conductive layer over and in contact with selected portions of the amorphous silicon and polysilicon regions; and
photolithographically patterning and etching to produce electrically isolated first and second devices, said first device having an amorphous silicon conductive region, said second device having a polycrystalline silicon conductive region, said first and second devices spaced apart from one another by between 2 and 50 micrometers.

Thus, the present invention and its various embodiments provide numerous advantages including, but not limited to significant reduction in inter-device spacing, simple integration into existing processes, etc., as described in further detail herein.

### BRIEF DESCRIPTION OF THE DRAWINGS

A more complete appreciation of the invention and many of the attendant advantages thereof will be readily obtained and understood by referring to the following detailed description and the accompanying drawings in which like reference numerals denote like elements as between the various drawings. The drawings, briefly described below, are not to scale.
Fig. 1 is a flow diagram illustrating the principle steps in the fabrication of closely spaced a-Si and poly-Si TFTs on a shared substrate.
Fig. 2 is a cross-sectional view of two devices being formed on a shared substrate at an initial stage in the process of forming same.
Fig. 3 is a cross-sectional view of two devices being formed on a shared substrate at an intermediate stage in the process of forming same.
Fig. 4 is a cross-sectional view of two devices being formed on a shared substrate at another intermediate stage in the process of forming same.
Fig. 5 is a cross-sectional view of two devices being formed on a shared substrate at still another intermediate stage in the process of forming same.
Fig. 6 is a cross-sectional view of two devices being formed on a shared substrate at yet another intermediate stage in the process of forming same.
Fig. 7 is a cross-sectional view of two devices being formed on a shared substrate at a further intermediate stage in the process of forming same.
Fig. 8 is a cross-sectional view of two devices being formed on a shared substrate at a still further intermediate stage in the process of forming same.
Fig. 9 is a cross-sectional view of two devices being formed on a shared substrate at a yet further intermediate stage in the process of forming same.
Fig. 10 is a cross-sectional view of two completed devices formed on a shared substrate according to one embodiment of the method of the present invention.
Fig. 11 is a cross-sectional view of an alternate structure that can be formed with the method according to the present invention.
Fig. 12 is a cross-sectional view of a further alternate structure that can be formed with the method according to the present invention

### DETAILED DESCRIPTION

In the following detailed description, numeric ranges are provided for various aspects of the embodiments described, such as flow rates, temperatures, layer thicknesses, etc. These recited ranges are to be treated as examples only, and are not intended to limit the scope of the claims hereof. In addition, a number of materials are identified as suitable for various facets of the embodiments, such as for substrates, dielectric and insulation layers, metalization, etc. These recited materials are also to be treated as exemplary, and are not intended to limit the scope of the claims hereof.

As a matter of terminology, reference herein to a-Si devices include devices in which at least the conductive portion thereof is formed substantially of a-Si. A TFT in which the channel region is formed substantially of a-Si is one example of an a-Si device. Other examples include a thin film capacitor, varactor, resistor, etc. in which at least one conductive region of such device is a-Si. Likewise, reference herein to poly-Si devices include devices in which at least the conductive portion thereof is formed substantially of poly-Si. A TFT in which the channel region is formed substantially of poly-Si is one example of a poly-Si device. Furthermore, device as used herein includes but is not limited to transistors, thin film capacitors, varactors, resistors, and other devices. Finally, use of the term conductive, such as a conductive layer or conductive material as used herein includes semiconductors, but may in certain applications include additional materials such as metals, and the like.

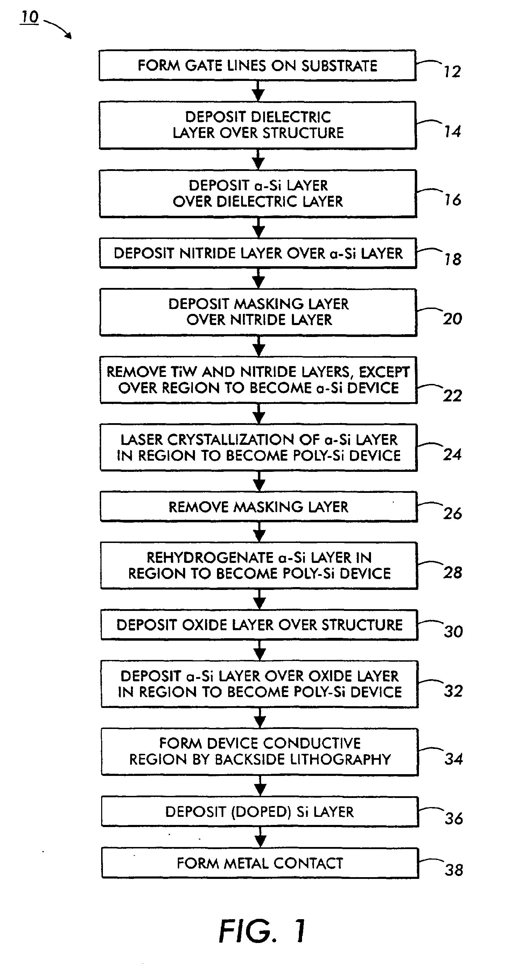

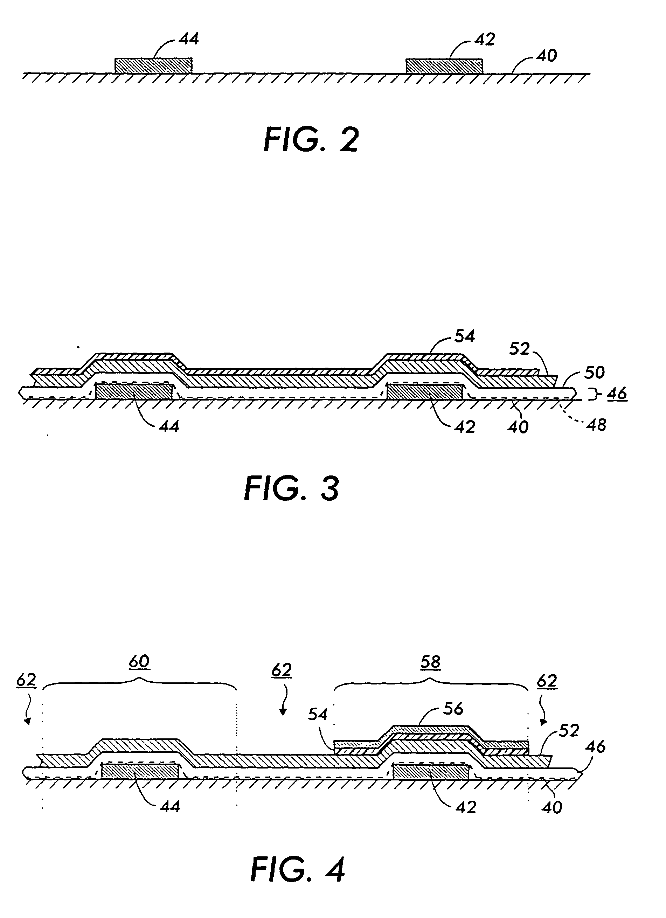

With reference to Fig. 1, a flow diagram is shown, illustrating the principle steps of a process 10 for forming two closely spaced TFTs on a shared substrate according to one embodiment of the present invention. Various of the steps illustrated in Fig. 1 correspond to the state of a structure at various steps in the process of making same illustrated in Figs. 2 through 10. Accordingly, cross-reference will be made between Fig. 1 and Figs. 2 through 10 where appropriate.

Process 10 begins at step 12 (Fig. 1) by forming conductive regions, or gate lines 42 and 44 (Fig. 2), of a conductive metal such as CrMo or other suitable material, on a cleaned and appropriately prepared substrate 40. Substrate 40 may be a material such as Corning 7059 or similar material which is transparent to ultra violet radiation of the type employed by subsequently described back side lithography, depending on the particular application. A dielectric layer 46 is then deposited at step 14 over the structure, covering gate lines 42 and 44. Dielectric layer 46 may be a single layer of material such as SiN, or be comprised of multiple sublayers, for example SiN and SiO₂ as taught by copending U.S. patent application 08/096,313. In the later case, the SiN sublayer 48 is deposited by plasma enhanced chemical vapor deposition (PECVD) at about 350 °C over gate lines 42, 44 and substrate 40. The SiO₂ sublayer 50 is likewise deposited by PECVD at about 350 °C over SiN layer 48. Alternatively, layer 46 may be an insulating layer other than a dielectric where appropriate.

At step 16, a layer 52 of semiconductor material, such as hydrogenated amorphous silicon (a-Si:H), is deposited over dielectric layer 46. An Si:H layer 52 is formed by PECVD at about 275 °C. It is important to note however, that according to examples not being part of the present invention other materials may be substituted for silicon, depending on the application of the resulting device. For example, gallium arsenide (GaAs), silicon germanium (SiGe), silicon carbide (SiC), pure germanium, etc. may be deposited in an amorphous state, and locally crystallized in situ to produce one or more regions of polycrystalline material. Selection criteria and deposition techniques for other semiconductor materials is known in the art, and will not be discussed further herein.

At step 18, a dielectric layer 54 is deposited over a-Si:H layer 52. The material from which layer 54 is formed is preferably a nitride such as SiN to provide a low leakage current device.

At step 20, a masking layer 56 is deposited over the dielectric layer 54. The role of this masking layer will be to shield the region of layer 52 which will become the channel of the a-Si device from laser light during the laser crystallization process. This material must be deposited under conditions consistent with the integrity of the structure (temperature, materials, etc.). Also, layer 56 will be patterned as described further below, so it must be of a material which may be selectively etched during processing. Finally, layer 56 must shield regions below it from the radiation used to crystallize a portion of layer 52. We have found that an alloy of titanium and tungsten (TiW) serves this purpose well, although there may be many other materials or combination which are able to function at least adequately as a masking layer, such as Cr or Al. We have found, however, that layer 56 works best in conjunction with layer 54 to protect regions of layer 52. Thus, for example, it is advantageous to employ TiW of layer 56 with SiN of layer 54, or equivalently Al as layer 56 with SiN of layer 54, etc. Accordingly, in the case where layer 56 is TiW, it may be deposited by sputtering, for example at room temperature, using D.C. magnetron sputtering, or the like. We have found that a 1000 Å thick TiW layer provides the desired functions of layer 56. The resulting structure is essentially as shown in Fig. 3.

It will assist the reader at this point to divide the structure being formed into three regions. First is region 58 in which the a-Si device will be formed. Second is region 60 in which the poly-Si device will be formed. And third is region outside of the first and second regions.

At step 22, the dielectric layer 54 and the masking layer 56 are removed from all but the first region. This is accomplished by depositing a photoresist layer (not shown) over layer 56, and exposing and developing same as well known in the art. Etching in H₂O₂ removes the desired portions of TiW layer 56 and stops at the SiN layer 54. Desired portions of the SiN layer 54 are then removed with a buffered HF etch. However, since buffered HF does not etch a-Si layer 52, it remains unaffected by the etching of layers 54 and 56. The resulting structure at this point in the process is as shown in Fig. 4.

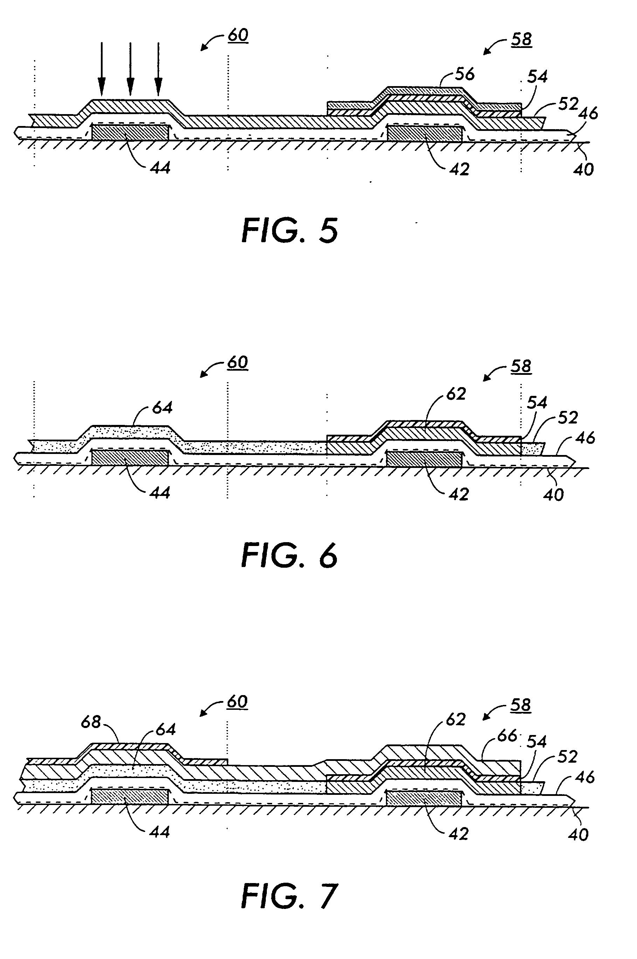

At step 24, a region of a-Si:H layer 52 in region 60 will be crystallized to form the channel of the poly-Si TFT. This crystallization is accomplished by directing laser light into the region to be crystallized. One technique for accomplishing this laser crystallization is described in detail in U.S. patent 5,366,926. Typically, a pulsed ultra violet (UV) excimer laser with gaussian output is used, with a pulse width on the order of 10 nsec. The laser beam is directed toward a beam homoginizer creating a square profiled beam. At this point in the process, the structure shown in Fig. 5 is retained on an x-y stepper within a vacuum chamber. The laser beam is directed through a window in the vacuum chamber so as to be incident upon the desired region of layer 52. The x-y stepper moves the substrate as required to cause the laser beam to sweep over the structure to form any additional devices to be formed on substrate 40. Importantly, masking layer 56 which is patterned so as to be located only in region 58, will protect the a-Si:H layer 52 thereunder from the laser crystallization process. This will allow the formation of the a-Si TFT in region 58.

A first pulse of the laser beam on the upper surface of layer 52 has an energy on the order of about 150 mJ/cm². Following this first pulse, the x-y stepper moves the structure a small amount. A second pulse of about 150 mJ/cm² is applied to the upper surface of layer 52. By a small amount, it is meant that the structure is moved such that the surface area of layer 52 irradiated by the second pulse overlaps the surface area of layer 52 irradiated by the first pulse by about 95%. The process is continued as required to irradiate at least all of the layer 52 within region 60. This process is then repeated again over layer 52 at a laser beam pulse energy of about 300 mJ/cm². A final pass over the structure with a laser beam pulse energy of at least about 350 mJ/cm² or greater produces a polycrystalline region 64 of layer 52. The average grain size in region 64 exceeds 1000 nm in the lateral direction.

As will be apparent to one skilled in the art, other laser crystallization techniques and apparatus may be employed without departing from the scope of the present invention, as defined by the appended claims.

Due to the proximity of regions 58 and 60, which is on the order of between 2 and 50 µm from edge to edge, masking layer 56 is required to fully isolate that part of layer 52 in region 58 from any laser energy. Layer 52 is thereby effectively divided into two regions. Region 62 is composed of a-Si:H basically as-deposited. Region 64 is poly-Si (or crystallized a-Si).

As mentioned, the purpose for layer 56 is to act as a mask during the laser crystallization process. At this point in the process, the laser crystallization has been performed, and thus layer 56 may be fully removed from the structure. While not strictly required, its removal is preferred, and removal is shown at step 26 of Fig. 1.

One consequence of the laser crystallization process is the hydrogen in layer 52 is driven off in the crystallized regions. Rehydrogenation is required to passivate the induced defects in the crystallized region to obtain optimal device performance from the poly-Si TFT. This rehyrdogenation is shown at step 28 of Fig. 1. Rehydrogenation may be accomplished, for example, by placing the structure in a hydrogen plasma, and heating to about 250 °C for about 20 minutes. Other rehydrogenation techniques may also be employed.

The hydrogen plasma employed to rehydrogenate the crystallized regions of layer 52 will etch exposed a-Si. Thus, it is important that region 62 of layer 52 be protected from the rehydrogenating plasma. Layer 54, having been appropriately patterned with masking layer 56, is thus used as a mask to protect region 62 from etching by the plasma. The resulting structure is shown in Fig. 6.

Following the rehydrogenation process, at step 30, a dielectric layer 66 is deposited over at least a part of the structure at step 32. Dielectric layer 66 is deposited at least over, and thus in physical contact with crystallized region 64 of layer 52. Accordingly, dielectric layer 66 is preferably an oxide material such as SiO₂ to maintain a low threshold for the poly-Si device to be formed in region 60. The oxide layer may be deposited by plasma enhanced chemical vapor deposition (PECVD) at 250 °C. The layer thickness is about 200 nm.

At step 32, an absorption layer 68 is deposited over the structure and patterned and etched to leave the layer in region 60. Layer 68 will absorb some of the UV radiation used in the lithographic formation of the channel of the poly-Si TFT, as further described herein. Absorption layer 68 may be formed of one or more of many different materials which absorb UV radiation. To simplify the manufacturing process, layer 68 may be formed of a-Si. However, other materials from which layer 68 may be formed include Ge, SiGe, SiC, etc. The structure at this point in the manufacturing process is shown in Fig.7.

At step 34, backside lithography is performed to form the discrete channels of the a-Si TFT in region 58 and the poly-Si TFT in region 60. Initially, a layer of UV curable photoresist (not shown) is deposited over the structure. Substrate 40 is transparent to UV light, and likewise to a greater or lesser degree are all layers of the material deposited thus far, with the exception of gate metals 42 and 44 which are opaque to UV light. The UV light is directed from below through substrate 40, through the deposited layers, and impinges the photoresist, exposing it except where blocked by the gate metals 42 and 44. The photoresist is developed where it has been exposed to UV light. The patterned photoresist is used as a mask to etch absorption layer 68, dielectric layer 66, and dielectric layer 54. As an example, Shipley 1813 photoresist may be employed using back side exposure for approximately 60 seconds with a 200 watt ultra violet lamp. Shipley 320 developer may then be employed.

One consequence of the formation of poly-Si material in region 64, while leaving a-Si:H region 62 essentially as-deposited is that poly-Si is more transparent to UV light than a-Si:H. Thus, proper exposure time for the backside lithography of step 34 will differ for regions 58 and 60. Specifically, exposure time for region 58 will be longer than exposure time for region 60. On the one hand, should the exposure time proper for region 58 be employed, the photoresist in region 64 will absorb more UV light energy than the photoresist in region 62. The principle consequence of this is a narrower channel structure in region 60 due to refraction and over exposure. We have found that this effect can result in a reduction in channel width of as much as 2 µm, which is significant when the total channel length is 5-10 micrometers. On the other hand, should the exposure time proper for region 60 be employed, the photoresist in region 58 will be under exposed and the channel subsequently formed will be poorly defined.

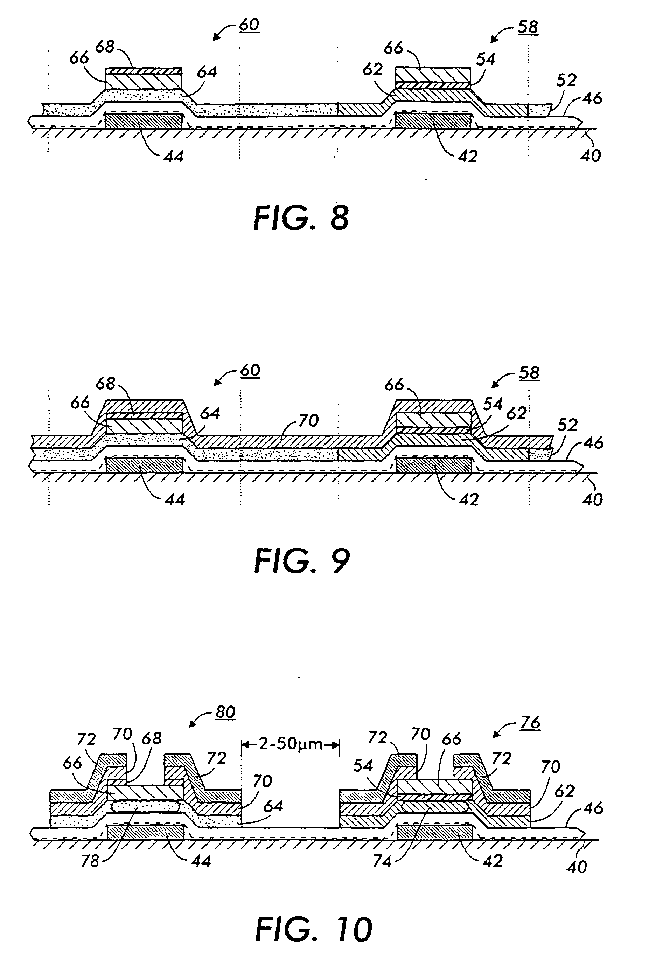

To compensate for this difference in transparency between a-Si:H and poly-Si, absorption layer 68 is employed above dielectric layer 66 and below the photoresist. As mentioned, layer 68 may be formed of one or more materials selected from a large list including Si, Ge, SiGe, SiC etc. Preferably, layer 68 will be formed of a-Si since that material is obviously compatible with the deposition processes employed. The extent of absorption of layer 68 will depend on both the layer's composition and its thickness. Target thickness for layer 68 consistent with the above-described embodiment is 50-100 nm. The structure at this point is substantially as shown in Fig. 8.

At step 36, a layer of a-Si:H 70 is deposited over the structure which shall form source and drain electrodes for the two TFTs. Layer 70 may be replaced by the direct doping of layers 62 and 64 in appropriate cases. In the latter case, one of many doping techniques may be employed, such as implantation, laser doping (for example as taught by U.S. patent application 08/927,023US 6107641), etc. The structure at this point in the process is as shown in Fig. 9.

At step 38, a conductive layer (not shown) of, for example, TiW/Al is deposited over a-Si layer 70 which shall form the contacts for the source and drain of the two TFTs. The conductive layer is etched by standard lithography and wet etching (or other similar process) to form source and drain contacts 72. a-Si layer 70, portions of layer 68, and portions of layer 52 are also etched by the above lithography and etching process. A discrete a-Si:H channel 74 is thus provided for a completed a-Si TFT 76, and a discrete poly-Si channel 78 is thus provided for a completed poly-Si TFT 76, as shown in Fig. 10. Proper contacts are made and a passivation layer (not shown) will ultimately be deposited over the structure to complete the device.

Described above has been a process for producing two adjacent TFTs, with an edge to edge spacing as small as between 2 - 50µm, for example between 2 and 5 µm. It will be appreciated that there are a number of variations apparent from the foregoing description.

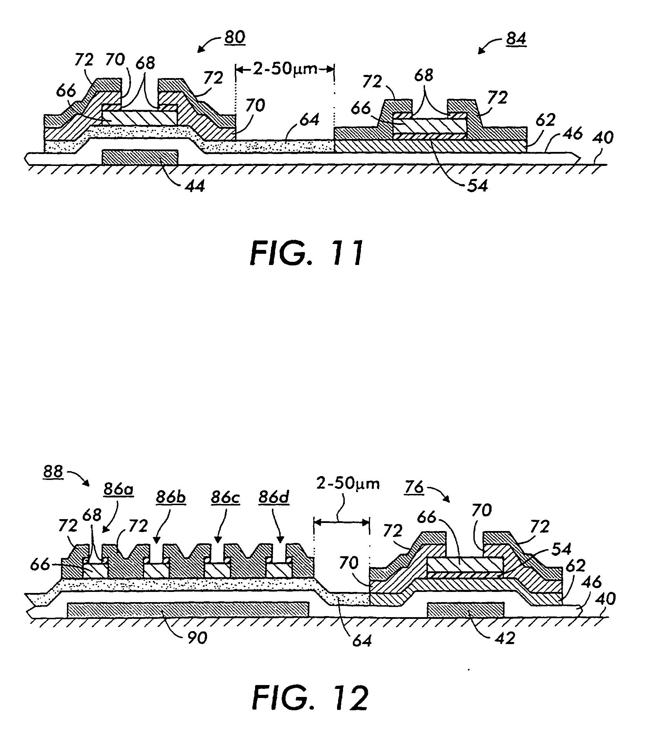

For example, in place of forming TFT 76, the above described process may be modified to produce other a-Si based devices such as a-Si resistor 84, shown in Fig. 11. The steps in process 10 are modified first by forming device 84 without a gate line 44. Instead, layer 52 is formed directly over and in contact with dielectric layer 46 in the region in which device 84 will be formed. Dielectric layers 54 and 66 are deposited as previously described. Absorption layer 68 is formed over dielectric layer 66, to absorb ultra violet radiation used in the back side lithography process. Contact layer 72 may next be deposited over and in contact with a-Si layer 52, removing the doped layer 70 from device 84.

A gap is formed dividing at least the contact layer 72 and absorption layer 68 into electrically isolated first and second regions, with a conduction path therebetween through a-Si layer 52. In this way, an a-Si resistor may be formed together with a poly-Si TFT on a shared substrate, with a spacing of between 2 and 50 micrometers. Advantageously, the a-Si provides high resistivity to the device. Of course, other a-Si devices may be similarly formed.

Likewise, devices other than a TFT may be formed of poly-Si on a shared substrate with an a-Si device. For example, shown in Fig. 12 is a varactor 88 formed on a shared substrate, and within 2 to 50 micrometers edge to edge of a-Si TFT 76. In this example, a-Si TFT 76 is formed as previously described. A plurality of stations 86a, 86b, 86c, 86d, etc. are formed over crystallized region 64 of layer 52. Each station consists of dielectric 66, absorption layer 68, and contact layer 72, formed over a single large contact line 90. Gaps separate contact layer 72 into first and second regions over each station, and the capacitance of the device may be selected by selectively contacting one or more of the separate stations. An advantage of this architecture is that a varactor with fast AC response time is obtained.

Finally, it will be apparent that while TFTs have been the focus of the above description, the present invention produces devices sharing a common substrate, and formed with 2 to 50 micrometers of one another, where neither device is a TFT. Accordingly, the above descriptions should be read as illustrative only, and should not limit the scope of the claims except if and where otherwise indicated.

## Claims

1. A method of producing a structure of at least two devices on a shared substrate (40), each said device having a region of conductive material in one of two crystalline states, said structure containing at least two said devices having different crystalline states adjacent one another, comprising the steps of:
forming first and second contact regions (42, 44) on the substrate (40);
forming a first insulating layer (46) over and in contact with said first and second contact regions (42, 44) and the substrate (40);
depositing a layer of conductive material (52) having a first crystalline state over and in contact with said first insulating layer (46) such that there is a region of conductive material overlying said first contact region (42) and a region of conductive material overlying said second contact region (44);
depositing a second insulating layer (54) over and in contact with said layer of conductive material (52);
depositing a masking layer (56) over and in contact with said second insulating layer (54) such that said masking layer (56) overlays said first contact region (42) but not said second contact region (44); and
selectively altering the crystalline state of said layer of conductive material (52) from a first crystalline state to a second crystalline state at least in the region overlying said second contact region (44), said masking layer (56) serving to prevent the crystalline state of the region of said conductive layer (52) overlying said first contact region (42) from being altered to said second crystalline state;
and wherein
each said device has either an amorphous or polycrystalline silicon layer, said structure containing at least one device having an amorphous silicon layer (62) adjacent at least one device having a polycrystalline silicon layer (64), and
said formed first and second contact regions (42, 44) are first and second gate lines;
said first formed insulating layer (46) is a first dielectric layer;
said deposited layer of a conductive material (52) is a hydrogenated amorphous silicon layer over and in contact with said first dielectric layer such that there is a region of amorphous silicon (62) overlying said first gate line (42) and a region of amorphous silicon overlying said second gate line (44);
said second formed insulating layer (54) is a second dielectric layer over and in contact with said hydrogenated amorphous silicon layer (52);
wherein said step of selectively altering consists of:
crystallizing said amorphous silicon layer at least in the region overlying said second gate line by irradiating said amorphous silicon layer with a laser beam, thereby converting a region of said amorphous silicon layer into a region of polycrystalline silicon, said masking layer serving to prevent the crystallization of the amorphous silicon layer overlaying said first gate line;
and further comprising the steps of
introducing hydrogen atoms into the polycrystalline silicon region (64);
depositing a third dielectric layer (66) over and in contact with at least the polycrystalline silicon region (64);
forming an absorption layer (68) over and in contact with said third dielectric layer (66) overlying at least said polycrystalline silicon region (64);
forming a photoresist layer overlying at least said first and second gate lines (42, 44);
forming islands of dielectric material overlying said first and second gate lines (42, 44) by back side lithography, using said first and second gate lines (42, 44) as masks, said absorption layer (68) absorbing sufficient energy from the back side lithography process so as to compensate for any difference in the transparency of the amorphous silicon (62) and polycrystalline (64) silicon regions;
forming a doped conductive layer over and in contact with selected portions of the amorphous silicon (62) and polysilicon regions (64); and
photolithographically patterning and etching to produce electrically isolated first and second devices, said first device having an amorphous silicon conductive region (62), said second device having a polycrystalline silicon conductive region (64), said first and second devices spaced apart from one another by between 2 and 50 micrometers.

2. The method of claim 1, wherein the masking layer (56) is comprised of TiW which blocks the laser beam from impinging upon the region of the conductive layer (52) overlying the first contact region (42).

3. The method of claim 2, wherein said first and second devices are spaced apart from one another by between 2 and 5 micrometers.

4. The method of claim 1, wherein said masking layer (56) is removed prior to the introduction of hydrogen atoms, and the second dielectric layer (54) is used as a mask to prevent hydrogen atoms from being introduced into the amorphous silicon region (62).

5. The method of claim 1, wherein said step of forming a first dielectric layer (46) comprises the steps of forming a first dielectric sublayer (48) of SiN over and in contact with said first and second gate lines (42, 44) and the substrate (40), and forming a second dielectric sublayer (50) of SiO₂ over and in contact with said first dielectric sublayer (48).

6. The method of claim 1, wherein at least one of said device having an amorphous silicon layer (62) and the adjacent at least one device having a polycrystalline silicon layer (64) is a thin film transistor.

7. The method of claim 1, wherein said at least one device having an amorphous silicon layer (62) and the adjacent at least one device having a polycrystalline silicon layer (64) are thin film transistors.

## Patentansprüche

1. Verfahren zur Herstellung einer Struktur mit wenigstens zwei Einrichtungen auf einem gemeinsamen Substrat (40), wobei die Einrichtung einen Bereich aus leitfähigem Material in einem von zwei kristallinen Zuständen aufweist, die Struktur wenigstens zwei dieser Einrichtungen mit zwei unterschiedlichen kristallinen Zuständen nebeneinander enthält, umfassend die Schritte:
Formen erster und zweiter Kontaktbereiche (42, 44) auf dem Substrat (40);
Formen einer ersten Isolationsschicht (46) auf und in Kontakt mit den ersten und zweiten Kontaktbereichen (42, 44) und dem Substrat (40);
Abscheiden einer Schicht aus leitfähigem Material (52) mit einem ersten kristallinen Zustand auf und in Kontakt mit der ersten Isolationsschicht (46), so dass ein Bereich des leitfähigen Materials auf dem ersten Kontaktbereich (32) liegt und ein Bereich des leitfähigen Materials auf dem zweiten Kontaktbereich (44) liegt;
Abscheiden einer zweiten Isolationsschicht (54) auf und in Kontakt mit der Schicht aus leitfähigem Material (52);
Abscheiden einer Maskierungsschicht (56) auf und in Kontakt mit der zweiten Isolationsschicht (54), so dass die Maskierungsschicht (56) auf dem ersten Kontaktbereich (42), jedoch nicht auf dem zweiten Kontaktbereich (44) liegt; und
selektives Verändern des kristallinen Zustands der Schicht aus leitfähigem Material (52) von einem ersten kristallinen Zustand in einen zweiten kristallinen Zustand wenigstens in dem Bereich, welcher auf dem zweiten Kontaktbereich (44) liegt, wobei die Maskierungsschicht (46) dazu dient, zu verhindern, dass sich der kristalline Zustand des Bereichs der leitfähigen Schicht (52), welche auf dem ersten Kontaktbereich (42) liegt, in den zweiten kristallinen Zustand ändert, und wobei
jede der Einrichtungen entweder eine amorphe oder polykristalline Siliziumschicht aufweist, die Struktur, welche wenigstens eine Einrichtung enthält, eine amorphe Siliziumschicht (62) in der Nähe der wenigstens einen Einrichtung mit einer polykristallinen aufweist, und wobei
die geformten ersten und zweiten Kontaktbereiche (42, 44) erste und zweite Gate Lines sind;
die erste gebildete Isolationsschicht (46) eine erste dielektrische Schicht ist;
die abgeschiedene Schicht aus einem leitfähigen Material (52) eine hydrogenierte amorphe Siliziumschicht ist, auf und in Kontakt mit der ersten dielektrischen Schicht, so dass ein Bereich aus amorphem Silizium (62) vorhanden ist, welcher auf der ersten Gate Line (42) liegt und ein Bereich aus amorphem Silizium auf der zweiten Gate Line (44) liegt;
die zweite gebildete Isolationsschicht (54) eine zweite dielektrische Schicht ist, auf und in Kontakt mit der hydrogenierten amorphen Siliziumschicht (52);
wobei der Schritt des selektiven Veränderns besteht aus:
Kristallisieren der amorphen Siliziumschicht in wenigstens dem Bereich, welcher auf der zweiten Gate Line liegt, durch Bestrahlen der amorphen Siliziumschicht mit einem Laserstrahl, wodurch ein Bereich der amorphen Siliziumschicht in einen Bereich aus polykristallinem Silizium umgewandelt wird, wobei die Maskierungsschicht dazu dient, die Kristallisation der amorphen Siliziumschicht, welche auf der ersten Anschlussleitung liegt, zu verhindern;
und des Weiteren umfassend die Schritte
Einführen von Wasserstoffatomen in den polykristallinen Siliziumbereich (64);
Abscheiden einer dritten dielektrischen Schicht (66) auf und in Kontakt mit wenigstens dem polykristallinen Siliziumbereich (64);
Formen einer Absorptionsschicht (68) auf und in Kontakt mit der dritten dielektrischen Schicht (66), welche auf wenigstens dem polykristallinen Siliziumbereich (64) liegt;
Formen einer Photoresistschicht, welche auf den ersten und zweiten Gate Lines (42, 44) liegt;
Formen von Inseln aus dielektrischem Material, welche auf der ersten und zweiten Gate Line (42, 44) liegen, durch Rückseitenlithographie, unter Verwendung der ersten und zweiten Gate Line (42, 44) als Masken, wobei die Absorptionsschicht (68) ausreichend Energie von dem Rückseitenlithographieverfahren absorbiert, um so einen Unterschied der Transparenz des amorphen Silizium- (62) und polykristallinen (64) Siliziumbereichs zu kompensieren;
Formen einer dotierten leitfähigen Schicht auf und in Kontakt mit ausgewählten Bereichen der amorphen Silizium- (62) und Polysiliziumbereiche (64); und
Photolithographisches Mustern und Ätzen, um elektrisch isolierte erste und zweite Einrichtungen herzustellen, wobei die erste Einrichtung einen leitfähigen amorphen Siliziumbereich (62) aufweist, die zweite Einrichtung einen leitfähigen polykristallinen Siliziumbereich (64) aufweist und die erste und zweite Einrichtungen voneinander zwischen 2 und 50 Mikrometer beabstandet sind.

2. Verfahren nach Anspruch 1, wobei die Maskierungsschicht (56) aus TiW besteht, welches den Laserstrahl daran hindert, auf den Bereich der leitfähigen Schicht (52) aufzutreffen, welche auf dem ersten Kontaktbereich (42) liegt.

3. Verfahren nach Anspruch 2, wobei die ersten und zweiten Einrichtungen voneinander zwischen 2 bis 5 µm beabstandet sind.

4. Verfahren nach Anspruch 1, wobei die Maskierungsschicht (56) vor dem Einführen der Wasserstoffatome entfernt wird, und die zweite dielektrische Schicht (54) als eine Maske verwendet wird, um zu verhindern, dass Wasserstoffatome in den amorphen Siliziumbereich (62) eingeführt werden.

5. Verfahren nach Anspruch 1, wobei der Schritt des Formens einer ersten dielektrischen Schicht (46) die Schritte des Formens einer ersten dielektrischen Unterschicht (48) aus SiN auf und in Kontakt mit den ersten und zweiten Anschlussleitungen (42, 44) und dem Substrat (40) und des Formens einer zweiten dielektrischen Unterschicht (50) aus SiO₂ auf und in Kontakt mit der ersten dielektrischen Unterschicht (48), umfasst.

6. Verfahren nach Anspruch 1, wobei wenigstens eine der Einrichtungen mit einer amorphe Siliziumschicht (62) und die benachbarte wenigstens eine Einrichtung mit einer polykristalline Siliziumschicht (64) ein Dünnfilmtransistor ist.

7. Verfahren nach Anspruch 1, wobei die wenigstens eine Einrichtung mit einer amorphen Siliziumschicht (62) ist und die benachbarte wenigstens eine Einrichtung mit einer polykristallinen Siliziumschicht (64) ist, Dünnfilmtransistoren sind.

## Revendications

1. Procédé de production d'une structure d'au moins deux dispositifs sur un substrat partagé (40), chaque dit dispositif ayant une région de matériau conducteur dans un de deux états cristallins, ladite structure contenant au moins deux dits dispositifs ayant différents états cristallins adjacents l'un à l'autre, comprenant les étapes de :
formation d'une première et d'une deuxième régions de contact (42, 44) sur le substrat (40) ;
formation d'une première couche d'isolation (46) sur et en contact avec lesdites première et deuxième régions de contact (42, 44) et le substrat (40) ;
dépôt d'une couche de matériau conducteur (52) ayant un premier état cristallin sur et en contact avec ladite première couche d'isolation (46) de manière à ce qu'il y ait une région de matériau conducteur recouvrant ladite première région de contact (42) et une région de matériau conducteur recouvrant ladite deuxième région de contact (44) ;
dépôt d'une deuxième couche d'isolation (54) sur et en contact avec ladite couche de matériau conducteur (52) ;
dépôt d'une couche de masquage (56) sur et en contact avec ladite deuxième couche d'isolation (54) de telle manière que ladite couche de masquage (56) recouvre ladite première région de contact (42), mais pas ladite deuxième région de contact (44) ; et
modification sélective de l'état cristallin de ladite couche de matériau conducteur (52) d'un premier état cristallin jusqu'à un deuxième état cristallin au moins dans la région recouvrant ladite deuxième région de contact (44), ladite couche de masquage (56) servant à empêcher que l'état cristallin de la région de ladite couche conductrice (52) recouvrant ladite première région de contact (42) ne soit modifié jusqu'audit deuxième état cristallin ;
et dans lequel
chaque dit dispositif a une couche de silicium amorphe ou polycristallin, ladite structure contenant au moins un dispositif ayant une couche de silicium amorphe (62) adjacent à au moins un dispositif ayant une couche de silicium polycristallin (64), et
lesdites première et deuxième régions de contact (42, 44) formées sont une première et une deuxième lignes de grille ;
ladite première couche d'isolation (46) formée est une première couche diélectrique ;
ladite couche d'un matériau conducteur (52) déposée est une couche de silicium amorphe hydrogéné sur et en contact avec ladite première couche diélectrique de telle manière qu'il y a une région de silicium amorphe (62) recouvrant ladite première ligne de grille (42) et une région de silicium amorphe recouvrant ladite deuxième ligne de grille (44) ;
ladite deuxième couche d'isolation (54) formée est une deuxième couche diélectrique sur et en contact avec ladite couche de silicium amorphe hydrogéné (52) ;
dans lequel ladite étape de modification sélective consiste en :
la cristallisation de ladite couche de silicium amorphe au moins dans la région recouvrant ladite deuxième ligne de grille par irradiation de ladite couche de silicium amorphe avec un faisceau laser, convertissant ainsi une région de ladite couche de silicium amorphe en une région de silicium polycristallin, ladite couche de masquage servant à empêcher la cristallisation de la couche de silicium amorphe recouvrant ladite première ligne de grille ;
et comprenant en outre les étapes de
introduction d'atomes d'hydrogène dans la région de silicium polycristallin (64) ;
dépôt d'une troisième couche diélectrique (66) sur et en contact avec la région de silicium polycristallin (64) ;
formation d'une couche d'absorption (68) sur et en contact avec ladite troisième couche diélectrique (66) recouvrant au moins ladite région de silicium polycristallin (64) ;
formation d'une couche de résine photosensible recouvrant au moins lesdites première et deuxième lignes de grille (42, 44) ;
formation d'îlots de matériau diélectrique recouvrant lesdites première et deuxième lignes de grille (42, 44) par lithographie face arrière, en utilisant lesdites première et deuxième lignes de grille (42, 44) comme masques, ladite couche d'absorption (68) absorbant une énergie suffisante par le processus de lithographie face arrière pour compenser une quelconque différence de transparence des régions de silicium amorphe (62) et de silicium polycristallin (64) ;
formation d'une couche conductrice dopée sur et en contact avec des parties sélectionnées des régions de silicium amorphe (62) et de polysilicium (64) ; et
modelage des contours par photolithographie et gravure pour produire des premier et deuxième dispositifs électriquement isolés, ledit premier dispositif ayant une région conductrice de silicium amorphe (62), ledit deuxième dispositif ayant une région conductrice de silicium polycristallin (64), lesdits premier et deuxième dispositifs espacés l'un de l'autre d'entre 2 et 50 micromètres.

2. Procédé selon la revendication 1, dans lequel la couche de masquage (56) est composée de TiW qui empêche le faisceau laser de frapper la région de la couche conductrice (52) recouvrant la première région de contact (42).

3. Procédé selon la revendication 2, dans lequel lesdits premier et deuxième dispositifs sont espacés l'un de l'autre d'entre 2 et 5 micromètres.

4. Procédé selon la revendication 1, dans lequel la couche de masquage (56) est supprimée avant l'introduction d'atomes d'hydrogène, et la deuxième couche diélectrique (54) est utilisée comme un masque pour empêcher que des atomes d'hydrogène ne soient introduits dans la région de silicium amorphe (62).

5. Procédé selon la revendication 1, dans lequel ladite étape de formation d'une première couche diélectrique (46) comprend les étapes de formation d'une première sous-couche diélectrique (48) de SiN sur et en contact avec lesdites première et deuxième lignes de grille (42, 44) et le substrat (40), et de formation d'une deuxième sous-couche diélectrique (50) de SiO₂ sur et en contact avec ladite première sous-couche diélectrique (48).

6. Procédé selon la revendication 1, dans lequel au moins un dudit dispositif ayant une couche de silicium amorphe (62) et de l'au moins un dispositif adjacent ayant une couche de silicium polycristallin (64) est un transistor à films minces.

7. Procédé selon la revendication 1, dans lequel ledit au moins un dispositif ayant une couche de silicium amorphe (62) et l'au moins un dispositif adjacent ayant une couche de silicium polycristallin (64) sont des transistors à films minces.
